(19) Europäisches Patentamt
European Patent Office
Office européen des brevets

(11) **EP 4 683 228 A1**

(12) **EUROPEAN PATENT APPLICATION**

(43) Date of publication:
**21.01.2026 Bulletin 2026/04**

(21) Application number: **25190317.5**

(22) Date of filing: **17.07.2025**

(51) International Patent Classification (IPC):
**H03K 19/173** (2006.01)   **H03K 19/17728** (2020.01)
**H03K 19/17736** (2020.01)

(52) Cooperative Patent Classification (CPC):
**H03K 19/17728; H03K 19/1737; H03K 19/17736**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **19.07.2024 JP 2024115447
16.06.2025 JP 2025099933
04.07.2025 JP 2025114053**

(71) Applicant: **National University Corporation
Kumamoto
University
Kumamoto 860-8555 (JP)**

(72) Inventors:
• **SETO, Kenshu
Kumamoto (JP)**
• **IIDA, Masahiro
Kumamoto (JP)**

(74) Representative: **Sekiguchi, Kazuya
Keisen IP
Lochhamer Straße 75
82166 Gräfelfing (DE)**

(54) **PROGRAMMABLE LOGIC DEVICE AND FPGA USING THE PROGRAMMABLE LOGIC DEVICE**

(57)    Conventional FPGAs have a problem of improving implemented logic density, and there is a need for a programmable logic circuit with a new structure capable of solving this problem. There is provided a programmable logic circuit (26), comprising a plurality of lanes (27) sequentially connected in the programmable logic circuit in a direction of flow of input signals of this programmable logic circuit, wherein each of the plurality of lanes has one or more logic cells (27), inputs input signals (Ia-Id) into the lane to each logic cell via a program-controllable input-side selector circuit, and outputs output signals (Oa-Oc) from the each logic cell as input signals into a next sequential lane connected to this lane or/and outputs the output signals as output signals of this programmable logic circuit.

FIG. 10

**Description**

## CROSS-REFERENCE TO RELATED APPLICATION

This application claims the benefit of Japanese Patent Application No. 2024-115447, filed on July 19, 2024, Japanese Patent Application No. 2025-099933, filed on June 16, 2025, and Japanese Patent Application No. 2025-114053, filed on July 4, 2025, which are hereby incorporated by reference.

## FIELD OF THE INVENTION

The present invention relates to a programmable logic circuit device suitable for mounting on application-specific integrated circuits (ASICs) such as SoC, and an FPGA using this programmable logic circuit.

## BACKGROUND OF THE INVENTION

There are IC products called ASICs (Application Specific Integrated Circuits) that are custom-designed, manufactured, and provided for specific applications. ASICs are semiconductor integrated circuits designed and manufactured for specific devices and/or applications by combining required logic functions, but no change may be made to the on-board logic functions after the manufacturing.

However, in recent years, as ASICs grew in scale and cost, there have been increasingly more cases where logic upgrade is desirable due to the a problem discovered after the manufacturing, and/or cases where adding a new function is desirable. Accordingly, schemes have been adopted to enable problem corrections and/or function additions by incorporating a programmable logic circuit block such as a FPGA (Field Programmable Gate Array) device into the ASIC. Here, the FPGA section onboard the ASIC is called an "eFPGA (Embedded FPGA)."

Logic cells of eFPGAs use LUTs (Look-Up Tables) representing truth tables "as is." For memories used for LUTs, SRAMs are used for standard FPGAs not for onboarding ASICs, whereas in ASICs, designs using many small SRAMs are not easy. For this reason, FFs (Flip-Flops) are used in eFPGAs within ASICs. However, FFs generally require several times (e.g., 6 to 10 times) more area compared to SRAMs. Furthermore, when using LUTs with multiple outputs (e.g., 4-input 3-output LUTs), an FF must be added to all outputs (a total of 3 FFs for a 4-input 3-output LUT). Accordingly, the area of logic cells capable of implementing the same amount of logic in an eFPGA is several times larger than that in a standard FPGA. Thus, certain problems exist from the viewpoint of the implemented logic density.

Also, the wiring connection structure of eFPGAs is, in the case of a configuration called island style, a structure in which programmable logic blocks (LB) are arranged in a grid pattern, and the grid-patterned logic blocks are connected by connection boxes (CBs) and switch boxes (SBs).with connection boxes (CBs) and switch boxes (SBs) connecting the grid-patterned logic blocks. Within a logic block, multiple logic cells are provided and interconnected via local connection blocks (LCBs). Logic cells within logic blocks are typically M-output N-input LUTs (Look-Up Tables), but in connections via LCBs, most logic cells are connected in a "full crossbar connection," where all logic cell outputs are connected to all logic cell inputs, resulting in a large number of multiplexers and component memories required for wiring switching. This is also a cause of the inability to increase the implemented logic density of eFPGAs.

## SUMMARY OF THE INVENTION

As described above, conventional eFPGAs have the problem of improving implemented logic density, and there is a need for a programmable logic circuit with a new structure capable of solving this problem.

Considering the above situation, the purpose of the present invention is to provide a programmable logic circuit with a new structure capable of solving the above problem, an FPGA using this programmable logic circuit, and a logic block of the FPGA.

In order to overcome the above challenges, the inventors of the present invention focused on the netlist structure to conceive that a wiring architecture different from the conventional one may be provided, and completed a programmable logic circuit of the present invention, an FPGA using this programmable logic circuit, and logic blocks of the FPGA.

According to the present invention, the following invention is provided.

(1) A programmable logic circuit, comprising:

a plurality of lanes sequentially connected in the programmable logic circuit in a direction of flow of input signals of this programmable logic circuit,

wherein each of the plurality of lanes has one or more logic cells, inputs input signals into the lane to each logic cell via a program-controllable input-side selector circuit, and outputs output signals from the each logic cell as input signals into a next sequential lane connected to this lane or/and outputs the output signals as output signals of this programmable logic circuit,

wherein the logic cell comprises

basic logic cells constituting nodes of a gate-level netlist,

wherein the basic logic cells are programmable circuits configured by adding programmable NOT circuits to an input and an output of basic logic operation elements.

(2) The programmable logic circuit of the above (1), wherein
input signals of the each lane include the input signals of the programmable logic circuit.

(3) The programmable logic circuit of the above (2), wherein
at least one of the lanes receives input signals of the programmable logic circuit from a previous sequential lane that this lane is connected to.

(4) The programmable logic circuit of the above (1), wherein
at least one of the lanes has wiring for feeding back output signals from the logic cells as input signals of the previous sequential lane that this lane is connected to, or this lane.

(5) The programmable logic circuit of the above (1), wherein
at least one of the lanes has wiring for feeding forward output signals from the logic cells as input signals of a next sequential lane that this lane is connected to.

(6) The programmable logic circuit of the above (1), wherein
at least one of the lanes has wiring for skip-outputting output signals from the logic cells as input signals of another programmable logic circuit.

(7) The programmable logic circuit of the above (1), wherein

wherein each lane is

configured by mapping nodes on a logic cell-level netlist, which nodes constituting the netlist according to a hierarchy along a direction of flow from an input side to an output side, onto each logic cell provided in the each lane.

(8) The programmable logic circuit of the above (7), wherein
the node mapping is mapping onto each logic cell provided in the each lane according to a connection sequential order of the lane in the programmable logic circuit.

(9) The programmable logic circuit of the above (1), wherein
a flip-flop (FF) is provided on the output side of the logic cell provided in the each lance.

(10) The programmable logic circuit of the above (1), wherein
an output-side selector circuit is provided on the output side of the logic cell provided in the each lance.

(11) The programmable logic circuit of the above (1), wherein

wherein the logic cell is

made programmable to switch inputs and outputs of the basic logic cells depending on connection relationships of the nodes in the netlist.

(12) The programmable logic circuit of the above (11), wherein

wherein the logic cell comprises

a combinational logic cell composed of a combination of a plurality of the basic logic cells,

wherein the combinational logic cell comprises a plurality of basic logic cells which cover a plurality of nodes constituting a graph of the netlist.

(13) The programmable logic circuit of the above (12), wherein

when the number of the combinational logic cells is n, an integer equal to 2 or greater, and the number of inputs to each basic logic cell is m, an integer equal to 2 or greater,

the combinational logic cell is

a logic cell of $(m-1) \times n + 1$ inputs and n outputs, having n of basic logic cells with their input signals switch-ably combined and connected, in order to represent two or more patterns of node connections.

(14) The programmable logic circuit of the above (12), wherein

the combinational logic cell has a plurality of outputs;

one or plurality of selectors provided so that at least two or greater output signals from the combinational logic cell are entered therein, and configured so as to output selected signals; and

a flip-flop (FF) provided so that output signals from the selector are entered therein.

(15) The programmable logic circuit of the above (14), wherein
the one or plurality of selectors are further provided so that a constant signal is entered therein.

(16) The programmable logic circuit of the above (1), wherein
this programmable logic circuit is a logic block of an FPGA.

(17) An FPGA implemented with the programmable logic circuit of the above (1) as a logic block.

(18) A programmable logic circuit implemented in a logic block (LB) constituting an FPGA,

the programmable logic circuit comprising:
a combinational logic cell (PAE) consisting of a combination of a plurality of basic logic cells (PAs), and programmed so as to switch inputs and outputs of the basic logic cells depending on connection relationships of nodes in a netlist, for outputting a plurality of output signals; and
one or plurality of selectors provided so that at least two or greater output signals from the combinational logic cell are entered therein, and configured so as to output selected signals;
and
a flip-flop (FF) provided so that output signals from the selector are entered therein.

According to such a configuration, nodes on the netlist (nodes that constitute the netlist according to a hierarchy along a direction of flow from an input side to an output side) may be mapped to each logic cell provided in a plurality of lanes according to the number of levels in the lane. This eliminates the need to provide the "full crossbar connection" which connects outputs of all logic cells provided in the programmable logic circuit to inputs of all logic cells, thereby reducing the number of component memories required for programming.
Note that features viewed from other aspects and/or other configurations of the present invention are shown in the following description of embodiments of the invention and accompanying drawings.

## BRIEF DESCRIPTION OF THE DRAWINGS

Fig. 1 is a schematic diagram showing a wiring architecture of an island-style FPGA;

Fig. 2 is a schematic diagram showing logic cells having an LCB with full crossbar connections;

Fig. 3 is a schematic diagram showing a netlist of logic cells;

Fig. 4 is a schematic diagram showing logic cells according to one embodiment of the present invention;

Fig. 5 is a schematic diagram showing mapping of logic cells according to the one embodiment of the present invention;

Fig. 6 is a schematic diagram showing a lane in logic cells according to a variation example 1 of the one embodiment of the present invention;

Fig. 7 is a schematic diagram showing logic cells according to the variation example 1 of the one embodiment of the present invention;

Fig. 8 is a schematic diagram showing logic cells according to the variation example 1 of the one embodiment of the present invention;

Fig. 9 is a schematic diagram showing logic cells according to a variation example 2 of the one embodiment of the present invention;

Fig. 10 is a schematic diagram showing a PAE configuration according to the one embodiment of the present invention;

Fig. 11 is a schematic diagram describing technology mapping of the PAE according to the one embodiment of the present invention;

Fig. 12 is a schematic diagram describing the technology mapping of the PAE according to the one embodiment of the present invention;

Fig. 13 is a schematic diagram showing a PAE configuration according to the one embodiment of the present invention;

Fig. 14 is a schematic diagram showing a variation example of PAE according to the one embodiment of the present invention;

Fig. 15 is a schematic diagram showing a variation example of PAE according to the one embodiment of the present invention;

Fig. 16 is a schematic diagram showing a variation example of PAE according to the one embodiment of the present invention;

Fig. 17 is a schematic diagram showing a variation example of PAE according to the one embodiment of the present invention;

Fig. 18 is a schematic diagram showing variation examples of logic cells according to the one embodiment of the present invention;

Fig. 19 is a schematic diagram showing variation examples of logic cells according to the one embodiment of the present invention;

Fig. 20 is a schematic diagram showing variation examples of wiring of logic cells according to the one embodiment of the present invention;

Fig. 21 is a schematic diagram showing a variation example of wiring of a logic cell according to the one embodiment of the present invention;

Fig. 22 is a schematic diagram showing a variation example of wiring of a logic cell according to the one embodiment of the present invention;

Fig. 23 is a schematic diagram showing a variation example of wiring of logic cells according to the one embodiment of the present invention;

Fig. 24 is a schematic diagram showing a variation example of wiring of logic cells according to the one embodiment of the present invention;

Fig. 25 is a schematic diagram showing a variation example of wiring of logic cells according to the one embodiment of the present invention; and

Fig. 26 is a schematic diagram showing a variation example of wiring of logic cells according to the one embodiment of the present invention.

## DETAILED DESCRIPTION OF THE INVENTION

One embodiment the present invention will be described in detail below with reference to accompanying drawings.

Firstly, a basic concept of the present invention will be discussed in comparison with conventional configurations.

(Basic Concept)

As described above, full crossbar connection of logic cells in conventional LCBs, mainly targeting LUTs with interchangeable inputs, offer high degree of freedom for wiring, but require an extra numbers of wires and component memories for switching those wires, resulting in limited reduction of implementation density.

In contrast, the inventors of the present invention conceived that by considering the flow of signals from input to output in the netlist, it is possible to significantly reduce the number of wires and the number of component memories compared to the conventional full crossbar connection, and completed the present invention accordingly.

(Wiring Architecture of Island-Style FPGA)

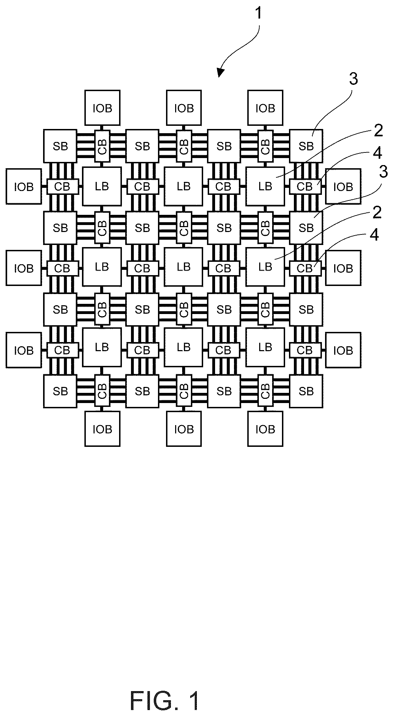

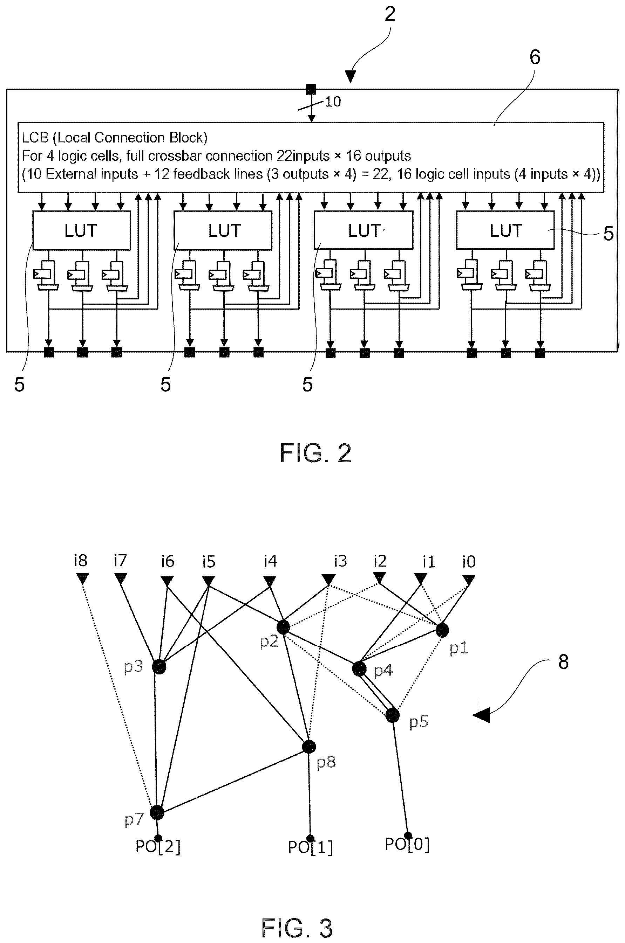

Fig. 1 is a schematic diagram showing a conventional island-style FPGA 1, and Fig. 2 is a conceptual diagram showing a wiring architecture within a logic block 2 arranged in this FPGA 1.

In this island-style FPGA 1, as shown in Fig. 1, logic blocks (LBs) 2 are arranged in a 2-dimensional matrix, and these logic blocks 2 are connected via programmable wiring such as switch blocks (SBs) 3, connection blocks (CBs) 4, and the like. In the above-described logic blocks 2, as shown in Fig. 2, a plurality of 4-input LUTs (look-up tables) 5 are provided as logic cells and these plurality of LUTs 5 are locally wired and connected via crossbar connections by local connection blocks (LCBs) 6. In these crossbar connections, considering the flexibility of logic circuit design, a wiring architecture is adopted that connects all outputs of any LUT 5 to all inputs of any logic cell. For this reason, it is referred to as a "full crossbar connection."

In the case of this full crossbar connection, the number of component memories required for the wiring within the logic block 2 is calculated as follows. For example, when the LUTs (logic cells) 5 implemented in this logic block are 4-input 3-output LUTs, and four of these 4-input 3-output LUTs are connected in parallel in a full crossbar configuration, the number of outputs of the LCB 6 providing this full crossbar connection is 16 (= 4 inputs $\times$ 4 units) in total for four logic cells since each logic cell has four inputs. On the other hand, the number of inputs is the sum of 10 external inputs and 12 (= 3 $\times$ 4) feedback lines from each logic cell, totaling 22 inputs.

Therefore, for this LCB 6, the number of component memories required to switch the internal wiring of the logic block 2 is calculated using the following formula and results in 80 bits.

$$4 \times 2 \times \mathrm{ceil}(\log2(22)) = 8{\times}4 = 80 \text{ bit}$$

Additionally, for an LCB 6 with 22 inputs and 16 outputs, since it means it has 16 multiplexers (MUXs) with 22 inputs and 1 output, 16 sets of 21 multiplexers with 2 inputs and 1 output (2-to-1) are required. Therefore, for this LCB 6, a total of 336 (= 21 $\times$ 16) 2-input 1-output multiplexers are required.

(Wiring Architecture of the Present Invention)

In contrast to the conventional wiring architecture using the LCB 6 described above, the present invention focuses on the netlist and provides a new wiring architecture that considers the signal flow from input to output which is considered to be typical in netlists.

Shown in Fig. 3 with the reference number 8 is a netlist in which a gate-level netlist has been replaced with 4-input 3-output logic cells in logic synthesis. In such a netlist 8, signals of calculation results generally flow from the inputs (i0-i8) to the outputs (P0[0]-P0[2]). Therefore, when designing a wiring architecture based on such a netlist 8, it is not necessary to connect all outputs of any logic cell to all inputs of any logic cell, as in a full crossbar connection.

Based on this insight, the logic block in an FPGA of the present invention provides a wiring architecture that does not connect all logic cells via the full crossbar connection, but instead uses groups of a plurality of logic cells (lanes) as basic units, arranges a plurality of lanes in order, and prioritizes connections between outputs and inputs among adjacent lanes.

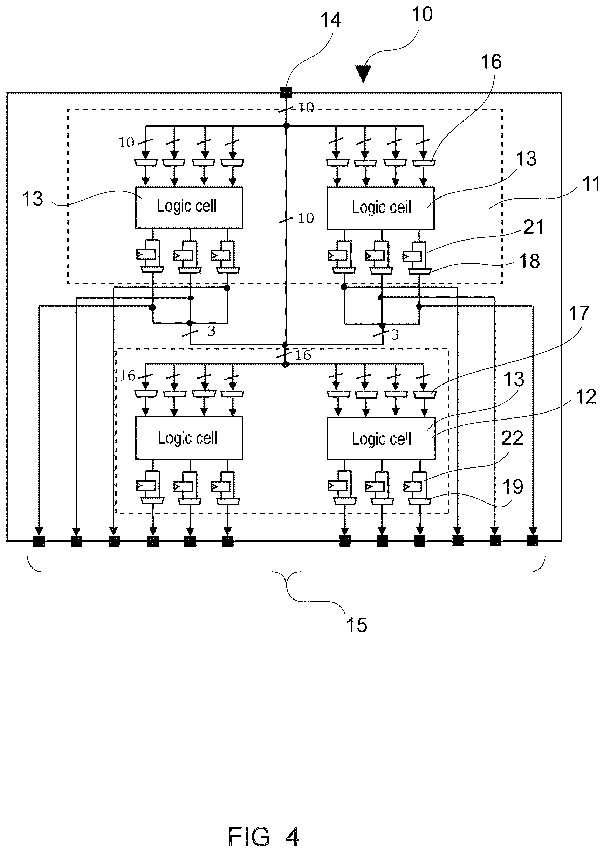

Fig. 4 shows a logic block 10 of an FPGA according to the first embodiment of the present invention. This logic block 10 has a first lane 11 (order level 1) sequentially connected and arranged from an input side to an output side of the logic block 10, and a second lane 12 (order level 2) arranged on the output side. In this logic block 10, four logic cells 13 are implemented, of which two in the first lane 11 and two in the second lane 12, respectively.

This logic block 10 is supplied with ten external input signals 14, and each of the logic cells 13 in the first lane 11 receives four input signals selected from the ten external input signals by input selector circuits (MUX: multiplexer) 16. Then, each of the logic cells 13 in the second lane 12 receives, in addition to the ten external input signals, four input signals selected by input selector circuits (MUX) 17 from a total of six internal input signals output from each of the logic cells 13 in the first lane 11.

Subsequently, output signals 15 of this logic block 10 are output through output selector circuits 18 and 19 provided on an output side of each logic cell 13, and the number of the signals is a total of 12, consisting of six signals from the first lane 11 and six signals from the second lane 12.

Note that, although not shown in this figure, additional wiring may be provided. For example, as needed, skip connection wiring (skip wiring) may be provided from particular wiring of the first lane 11 to other wiring blocks via optional flip-flops (FF). Also, the outputs of the logic cells 13 within a lane, as shown in this example, may pass through FFs 21 and 22. In this case, in order to suppress output signals that would increase wiring, output selector circuits (MUXs) 18 and 19 may be added.

Further, although not shown in this figure, unnecessary wiring may be removed. For example, each input selector circuit 17 of each logic cell 13 in the second lane 12 is capable of deleting some of the ten external input signals and some of the six signals from the first lane 11 to thereby make a selection from fewer wiring.

In the case of this logic block 10, the number of component memories required is calculated as follows.

That is, the total of four 4-input 3-output logic cells 13 implemented in this logic block 10 are arranged such that two logic cells 13 are in the first lane 11 and two logic cells 13 are in the second lane 12, respectively. In this case, the number of component memories for selecting the input signals for each logic cell 13 in the first lane 11 is calculated using the following formula and is 32 bits.

$$4 \times 2 \times \mathrm{ceil}(\log 2(10)) = 8 \times 4 = 32$$

Next, the number of component memories for selecting the input signals for each logic cell 13 in the second lane 12 is calculated using the following formula and, since the number of inputs is 16, it is 32 bits.

$$4 \times 2 \times \mathrm{ceil}(\log 2(16)) = 16 \times 4 = 32$$

Therefore, the number of component memories required to switch the internal wiring of this logic block is 64 bits (32 + 32) in total, which means that the number of component memories may be reduced by 20% compared to 80 bits required for a full crossbar connection.

In the case of this connection architecture, since each of the two logic cells 13 in the first lane has four input multiplexers with ten inputs, respectively, totaling eight, converting this to 2-input 1-output (2-to-1) multiplexers, 10 - 1 = 9 results in $2 \times 4 \times 9 = 72$ as the number of the 2-input 1-output multiplexers in the first lane.

Next, when similarly calculating for the second lane, there are eight 16-input multiplexers, and these 16-input multiplexers are equivalent to 15 of 2-input 1-output multiplexers, and therefore, the number of 2-input 1-output multiplexers in the second lane is $8 \times 15 = 120$.

Thus, for this logic block, a total of 192 (= 72 + 120) multiplexers are required.

Therefore, the size of the multiplexers may be reduced by at least 43% compared to the conventional 336.

(Clustering based on Netlist)

Next, a method for clustering a netlist using a logic block of the present invention (considered as one cluster) will be described using the netlist 8 shown in Fig. 3, which uses a 4-input 3-output logic cell, as an example. Note that in the following, the first lane 11 and the second lane 12 are sometimes referred to as order level 1, order level 2, and order level N, respectively, depending on the hierarchy (depth) of the netlist.

First, the logic block 10 of this first embodiment is described under the following conditions for the purpose of clustering.

- Number of logic cells in a cluster = 4

- Number of lanes in a cluster (lane order) = 2

- Maximum number of input signals = 10

- Maximum number of logic cells in the second lane (order level 1) = 1

- Maximum number of logic cells in the second lane (order level 2) = 2

In clustering, nodes constituting a netlist (black circles in the netlist in Fig. 3) that satisfy the above conditions, i.e., logic cells 13, are identified as clustering candidates.

First, as Step 1, the lane order is determined within the logic block 10. In this embodiment, since order levels consist of order level 1 and order level 2, the order is "2." When the order is "2," the logic block 10 may be mapped so as to cover two specific layers of the netlist hierarchy. Note that mapping within one layer is also possible.

Next, as Step 2, starting from the layer closest to the input side of the netlist, combinations of logic cells (nodes) that satisfy the above level conditions are selected. Then, the selected candidates are sequentially added as candidate logic cells to a selected candidate list.

Furthermore, as Step 3, clustering is performed by finally selecting logic cells that satisfy all other conditions among combinations of logic cells added to the candidate list, and at the end as Step 4, the selected (clustered) logic cells are deleted from the candidate list.

Then, Steps 2 to 4 are repeated to thereby fill each cluster with up to the maximum number of logic cells discussed above. If no further progress may be made, the clustering is restarted from Step 1 for nodes that have not been mapped.

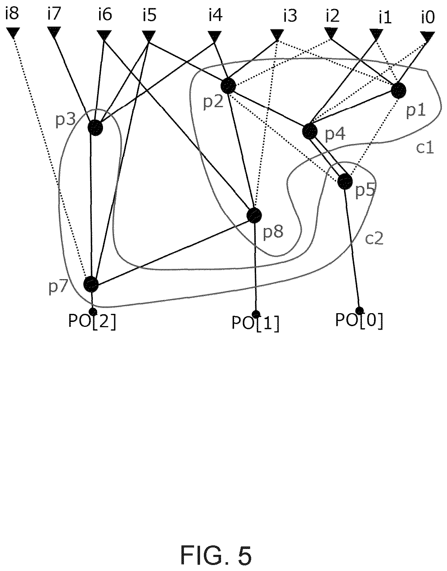

In the case of the above netlist example, as shown with C1 and C2 in Fig. 5, clustering may be performed into two logic clusters. These clusters C1 and C2 correspond to the logic blocks 10 described above, respectively.

Thus, when mapping a specific netlist using the logic block 10 of this embodiment example, as a result, compared to mapping the same number of logic cells assuming the logic block 2 having the LCB 6 with the conventional full crossbar connection, an area of the selector circuits used for internal wiring in the logic block 10 may be reduced by at least 43%, and the number of component memories of the selector circuits used for internal wiring may be reduced by at least 20%.

According to such a configuration, there are provided a programmable logic circuit with a novel configuration that solves the existing challenge of improving the implemented logic density in conventional eFPGAs, an FPGA using this programmable logic circuit, and logic blocks of the FPGA. Note that when configuring an FPGA using the logic block 10 of the above embodiment, the logic block 2 shown in Fig. 1 is replaced with the logic block 10 of this embodiment, but the wiring configuration and the number of wires among logic blocks are not limited to those shown in Fig. 1.

(Variation Example 1)

The logic block 10 of the above embodiment had two lanes 11 and 12 and a total of four logic cells 13 distributed and arranged into two in each lane, but it is not limited to this configuration, and depending on the target netlist, the lane order, the number of logic cells 13 in a lane, and/or the number of inputs and/or input signals of the selector circuits 16 and 17 may be customized.

In other words, the present invention is not limited to the above embodiment in terms of the total number of inputs and outputs, the number of logic cells 13, the number of inputs and/or connection methods of input selector circuits 16 and 17, the number of output selector circuits 18 and 19, the number of inputs and/or connection methods of output selector circuits 18 and 19, connection destination lanes, and whether or not output flip-flops (FFs) 21 and 22 are included.

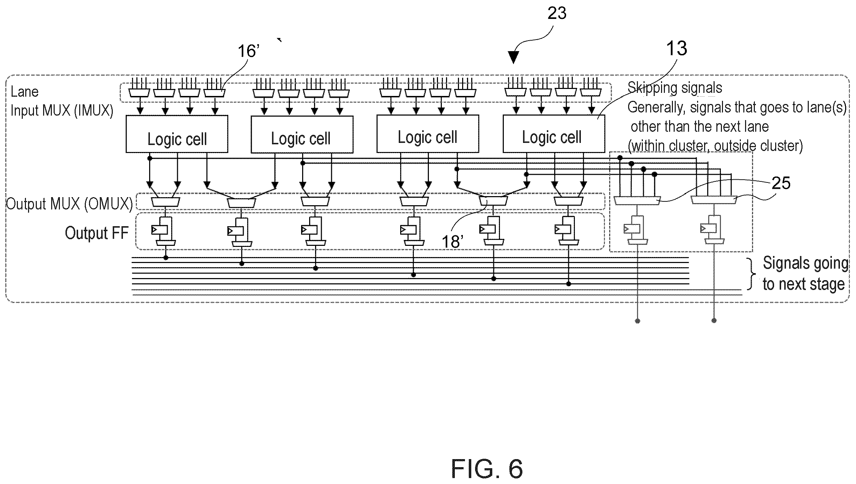

For example, in the example of lane 23 shown in Fig. 6, four logic cells are arranged in one lane 23. Also, in this example, one output selector circuit 18 is shared between two output terminals of logic cells 13. Further, this example provides wiring and signal selectors 25 (multiplexers) for extracting skipping signals (signals that goes to lanes other than the next lane).

The two signal selectors 25 shown in this figure connect the outputs of the logic cells 13 in this lane 23 to the input selector circuits of lanes other than the next lane. For example, they may connect to an input selector circuit X of a logic cell in a lane n order levels (including itself (n = 0)) before (feedback wiring) and/or connect to an input selector circuit of a lane m order levels after (feedforward wiring). Additionally, in this figure, there are two signal selectors 25 for skipping, but the number and connection methods of the signal selectors may be freely set.

Moreover, in this figure, some out of all outputs (total $3 \times 4 = 12$) of the logic cells in the lane are connected to the output selectors 25, but the method of selecting which outputs to connect is not limited to this, and all outputs may also be connected.

Note that in this example of Fig. 6, four logic cells are arranged in parallel, which is similar to the conventional example of crossbar connection shown in Fig. 2. Accordingly, for convenience, the number of component memories required in this example is calculated as below.

That is, four 4-input 3-output logic cells 13 are implemented in this lane 23. In this case, the number of component memories for selecting the input signals for each logic cell 13 in the first lane 23 is calculated using the following formula, assuming that the number of inputs to the input multiplexer is 16, and is 64 bits.

$$4 \times 4 \times \mathrm{ceil}(\log2(16)) = 16 \times 4 = 64$$

Also, for this configuration, since each of the four logic cells 13 in the first lane has four input multiplexers with ten inputs, respectively, totaling 16, converting this to 2-input 1-output (2-to-1) multiplexers, 10 - 1 = 9 results in $4 \times 4 \times 9 = 144$ as the number of the 2-input 1-output multiplexers in the first lane.

On the other hand, in this example, as described above, the one output selector circuit 18 is shared between two output terminals of logic cells 13. Also, one output selector circuit is shared between two output terminals of logic cells 13. In the example shown in this figure, the numbers of FFs and output multiplexers are both eight. Since there were 12 in the above embodiment, the configuration is simplified accordingly. The addition of output selector circuits 18 increases the component memories by $6 \times 1 = 6$ bits, and the addition of output selector circuits 25 increases them by $2 \times 2 = 4$ bits, resulting in a total increase of 10 bits, but compared to the embodiment shown in Fig. 2, the number of feedback lines may be reduced, and the overall component memories is reduced.

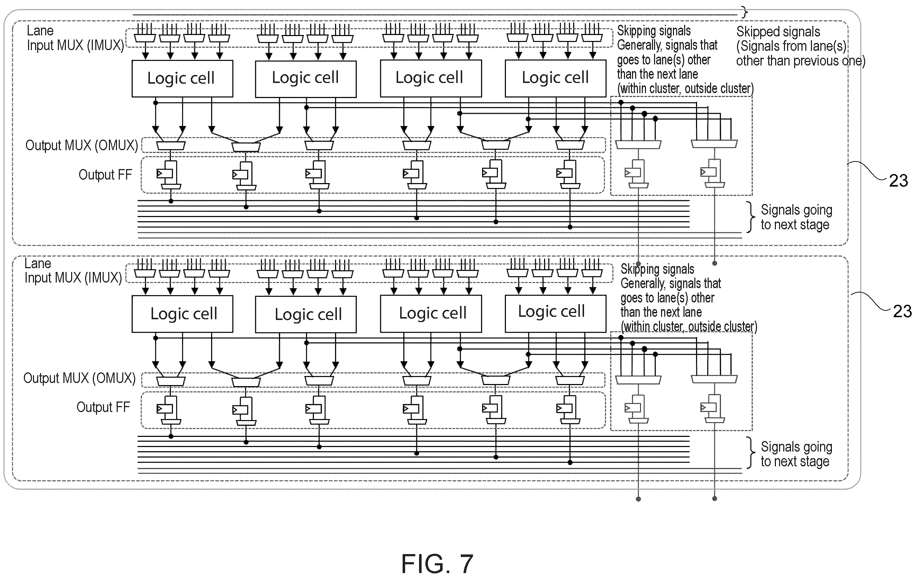

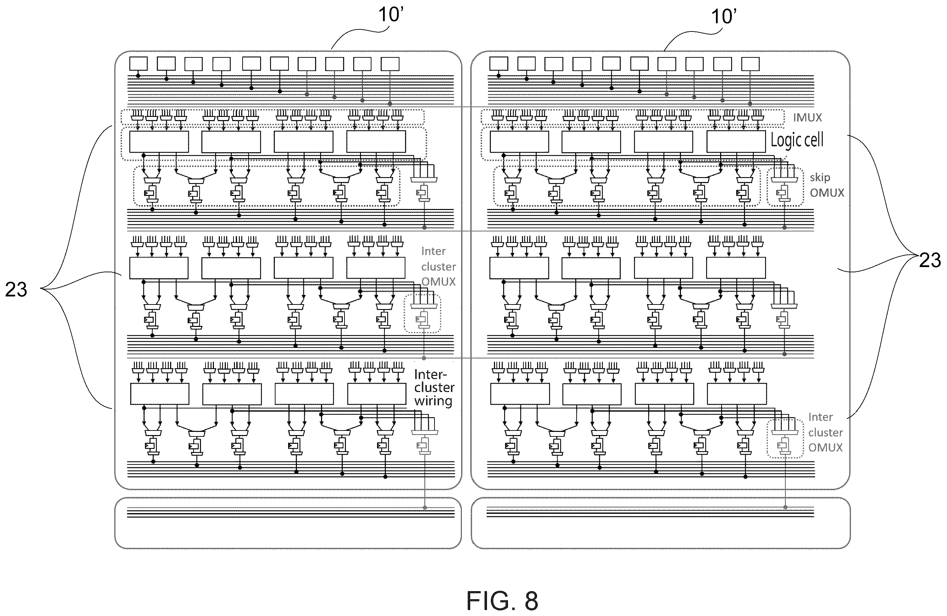

Additionally, Fig. 7 is an example of a logic block having two of the lane 23 shown in Fig. 6, and Fig. 8 is a diagram showing one logic block 10 provided with three lanes 23 and wiring among different logic blocks 10. This example has twice as many logic cells as the examples of Fig. 2 and Fig. 4, and although a simple comparison with the above conventional art may not be made, logic memories may be reduced by a significant number compared to a crossbar-connected logic block having the same number of logic cells.

(Regarding Logic Cells)

In addition, in the above embodiment, conventionally used LUTs may be used as logic cells, but when using a "PAE circuit (combinational logic cell)" capable of reducing the number of component memories of the logic cells themselves compared to conventional LUTs, the implementation density may be improved in addition to the above reduction of the number of component memories required for wiring.

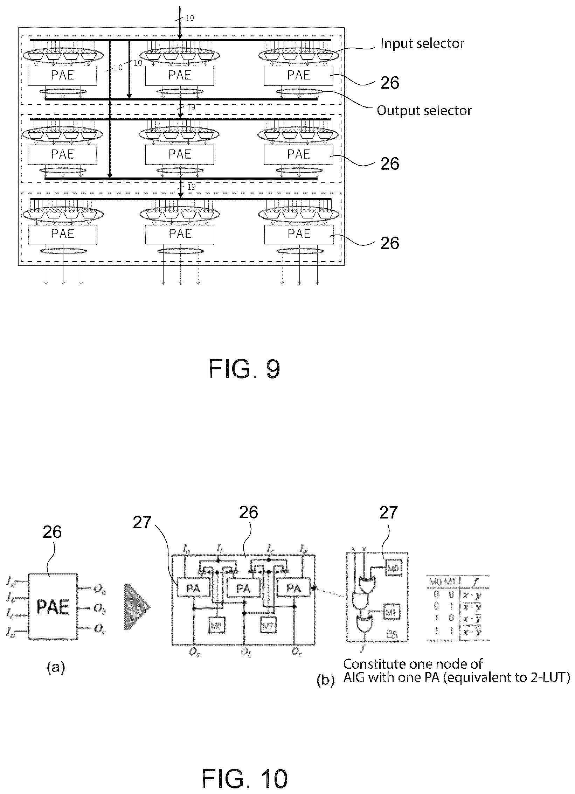

Fig. 9 shows an example of a logical block 10" provided with three levels of lanes, wherein each lane has three 4-input 3-output PAE circuits 26 arranged as logic cells. This PAE circuit 26 is, for example, as shown in Figs. 10(a) and (b), three PA circuits (programmable AND circuits: basic logic cells) 27 connected in a switchable manner. Further, each PA circuit 27 is a programmable circuit configured by adding a programmable inverted circuit (programmable NOT circuit) 29 to basic logic operation elements (AND gate, OR gate, NOT gate, etc.) 28, and according to the connection relationships among nodes in the netlist, each PA circuit 26 is made programmable so that it switches the inputs and outputs of the basic logic cells 27.

The number of component memories used in the PAE circuit 26 is 16 bits in the case of a 4-input LUT (4LUT), which is a conventional logic cell, whereas it is 8 bits, which is half of 16 bits, for the 4-input PAE circuit 26 of the present embodiment.

As an embodiment, simply replacing conventional 4-input 3-output LUTs with a 4-input 3-output PAEs as the logic cells of the first embodiment achieves an effect of reducing the number of component memories, but by performing technology mapping using PAEs as below, an actual implementation density may be further improved.

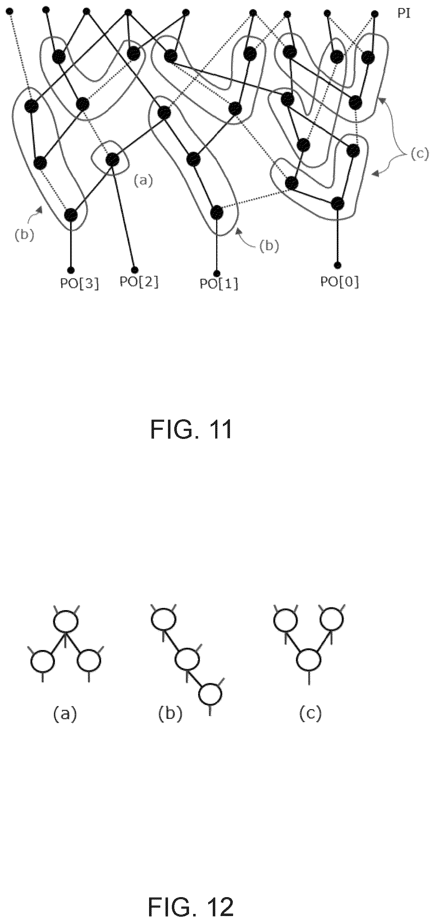

That is, in this case, a gate-level netlist (AIG) shown in Fig. 11 is used.

(1) Within the AIG, perform matching with any of the node graphs (a), (b), or (c) of Fig. 12 (node graphs showing PAEs);

(2) Perform mapping to logic cells;

(3) Return to (1) until all the nodes are covered; and

(4) End when all the nodes are mapped.

After mapping the netlist shown in Fig. 11 with 4-input, 3-output PAEs, it may be covered by lassos as shown in this figure. When mapping to the PAE circuits of this embodiment, outputs from nodes within the covered ranges may be utilized, so there is no occurrence of coverage overlap of target nodes. As a result, in this example, mapping may be done with eight of the 4-input 3-output combinational logic cells (the number of component memories is 8 bits), and the amount of component memories will be 8 bits × 8, that is, 64 bits. In the case of 4-LUTs, the technology mapping results require 14, thus, 16 bits × 14 = 224 bits. Accordingly, the PAE circuit has a 1/3 or less component memories amount of that using LUTs.

Furthermore, the average coverage ratio of the netlist in this embodiment is 2.52 nodes, exceeding the 2.43 nodes for the LUT. As a result, in an evaluation using 29 types of benchmark circuits in the present embodiment, an average component memory reduction rate reaches 51.6%, cutting down the component memories down to half. In addition, the maximum component memory reduction rate is 66.5%, and the minimum component memory reduction rate is 23.0%, reducing more memories than the conventional LUTs.

According to the examples discussed above, there is provided a programmable logic circuit (PAE and combinations thereof), comprising basic logic cells (PX circuits) for an embedded FPGA onboard an ASIC, for configuring nodes of a gate-level netlist, wherein these basic logic cells are programmable circuits configured by adding programmable NOT circuits to basic logic operation elements, and made programmable to switch inputs and outputs of the basic logic cells depending on connection relationships of the nodes in the netlist.

Note that the PAE circuits 26 described above were 4-input 3-output ones, but it is not limited to that configuration, as the number of inputs of a basic logic operation element is not limited to two.

According to the present embodiment, if a combinational logic cell is configured with a combination of two or more types of graphs, wherein each graph has n of m-input basic logic cells connected to one another, the number of inputs is $(m-1) \times n + 1$, and the number of outputs is n. Here, m and n may be any numbers equal to or greater than two, respectively.

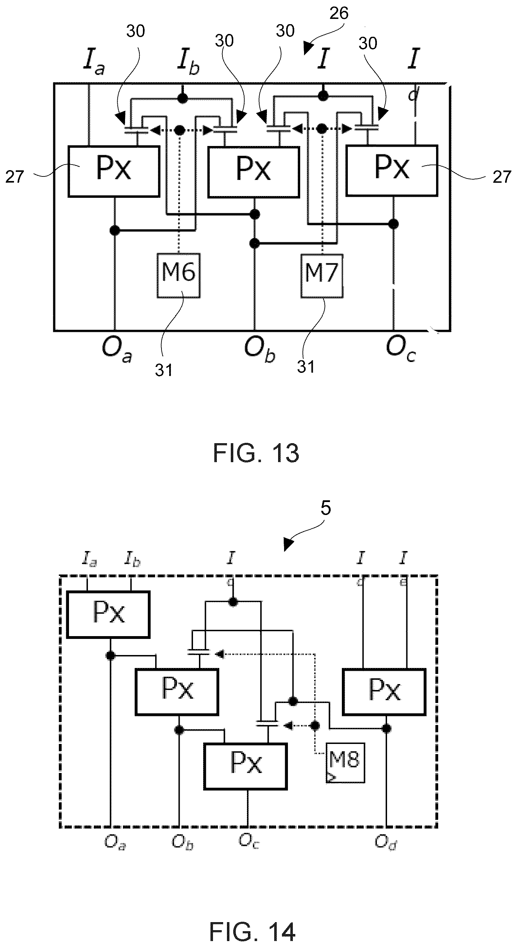

Fig. 13 is an enlarged view of the PAE circuit 26 shown in Fig. 10 (b). Also in this figure, the basic logic cells 27 labeled "PA" in Fig. 10 (b) are labeled "PX." This example shows a PAE circuit 26 when the number of inputs m of the basic logic cells (PX) 27 is two and the number of connected cells n is three. The number of inputs to this PAE circuit 26 is $(m-1) \times n + 1 = (2-1) \times 3 + 1 = 4$, and the number of outputs is n, that is, three. The connection relationships of the graph connecting the basic logic cells 27, each with the number of inputs m = 2, and n = 3 of the basic logic cells being connected, will have three patterns as in Figs. 12 (a)-(c) discussed above (circles indicate basic logic cells). This PAE circuit 26 has functionality (indicated with a reference number 30 in Fig. 13) to switch the connection relationships of internal logic nodes with a multiplexer or an equivalent circuit in order to implement such a plurality of node connection relationships. Further, this PAE circuit 15 has memories (indicated by symbol 31 in Fig. 13) for retaining switching information of the multiplexer or the like for connection switching, and is adapted so that it may configure internal memories 31 of the PAE circuit 26 according to the connection shapes of the nodes constituting the netlist.

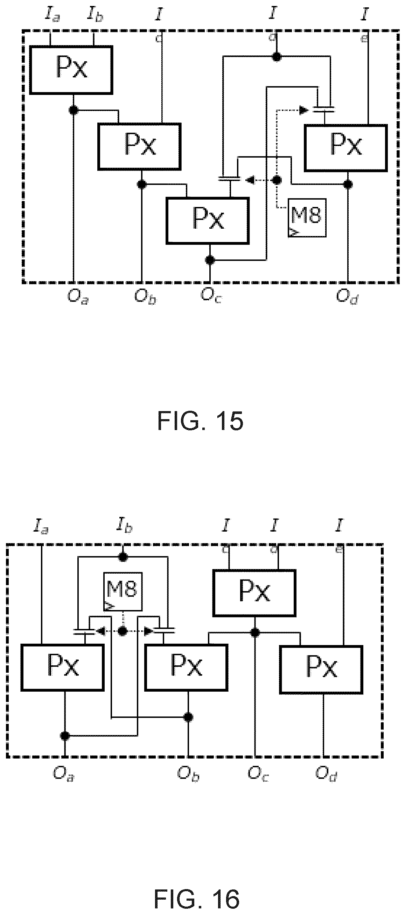

Additionally, in the case of connecting n = 4 basic logic cells 27 with m = 2 inputs, the number of graphs will be in 7 patterns (not shown), and the combination logic cells created by combining two types of these 7 patterns will be, for example, as shown in Fig. 14 to Fig. 17.

These examples implemented the connection relationships of two types of basic logic cells (nodes) in one combinational logic cell, but the number of logic cell types are not limited to two, and connection relationships of more than two types may be implemented in one combinational logic cell.

Further, the above example is for the case where the number of included basic logic cells is four, but the number of inclusions n is also arbitrary.

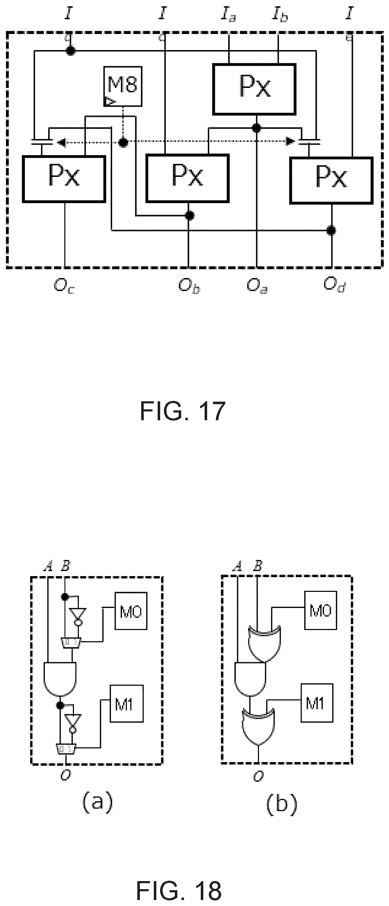

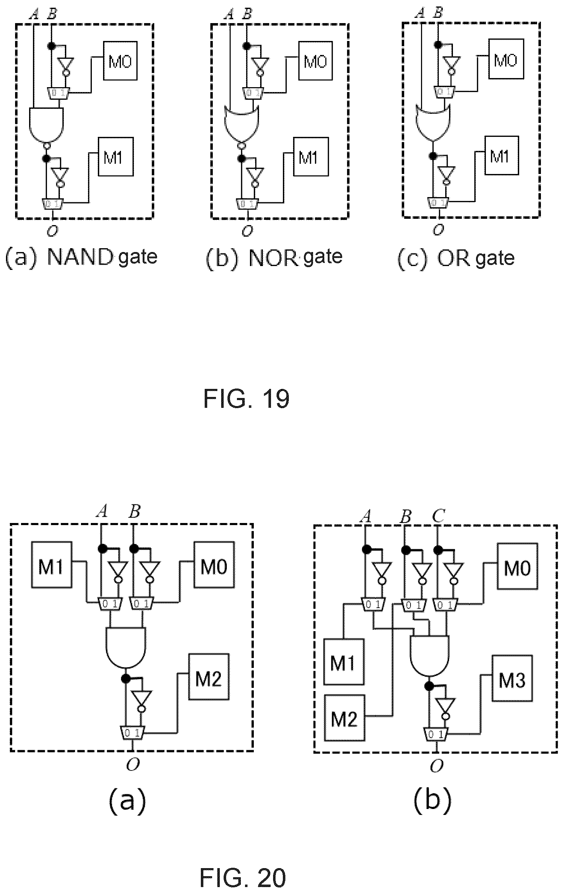

Note that the programmable NOT circuit 29 of the PA circuit 27 shown in Fig. 10 (b) may be implemented with a NOT gate and a multiplexer as shown in Fig. 18 (a), or implemented with an XOR gate as shown in Fig. 18 (b). Also, as the basic logic element 28, other than the AND gate and OR gate, a NAND gate and/or NOR gate may be used for configuration, as shown in Fig. 19.

In the above example, a programmable NOT circuit was placed at one input of the basic logic operation element, but as shown in Fig. 20 (a), it may also be placed at both inputs. Moreover, as shown in Fig. 20 (b), the number of inputs to the basic logic cell is not limited to two.

(Comparison of the Number of Component Memories)

The table below shows a comparison of the number of component memories when there are four logic cells as explained above.

| | Prior art | Present Invention | | | |
|---|---|---|---|---|---|
| | 4-input, 3-output LUT x 4, crossbar connection (Figure 2) | 2 LUT x 2 lanes LUT (when the logic cell in Figure 4 is an LUT) | 2 PAE x 2 lanes (when the logical cell is P AE in Figure 4) | 4 LUT x 1 lane (when the logic cell in Figure 6 is an LUT) | 4 PAE x 1 lane (when the logical cell is PAE in Figure 6) |
| Number of logic cell memories | 16 x 4 = 52 | 16 x 4 = 52 | 8 x 4 = 32 | 16 x 4 = 52 | 8 x 4 = 32 |
| FF number | 3 x 4 = 12 | 3 x 4 = 12 | 3 x 4 = 12 | 8 | 8 |
| Input multiplexer memory count | 80 | 64 | 64 | 64 | 64 |
| Output multiplexer memory count | 12 | 12 | 12 | 8 + 10 | 8 + 10 |
| Total | 156 | 140 | 120 | 142 | 122 |

It should be noted that the present invention is not limited to the above one embodiment, and that various changes and modifications may be made without departing from the spirit and scope of the present invention.

For example, each input selector circuit 17 of each logic cell 13 in the second lane 12 of the first embodiment (Fig. 4) is selected from the 10 external input signals to the second lane 12 and the 6 signals from the first lane 11, but it is not limited to this configuration, and some wiring may be deleted.

For instance, the logic cell 13 on the left side of the second lane 12 may select the leftmost four of the six outputs from the two logic cells 13 in the first lane 11, and similarly, the logic cell on the right side of the second lane 12 may select the rightmost four of the six outputs from the two logic cells 13 in the first lane 11. Further, the second lane 12 may select four different signals from the 10 external input signals. According to such a configuration, each input selector circuit 17 of the second lane 12 may perform a selection from eight wires.

As another example, the logic cells 13 of the second lane 12 may be configured so that the leftmost input signal is selected from the 16 signals among the four input signals, while for the other three input signals, the six output signals of the first lane 11 and two different signals among the external input signals are selected at each logic cell 13. Accordingly, the logic cells 13 in the second lane 12 may select only the leftmost input from the 16 wires, and the other three inputs may be selected from eight wires.

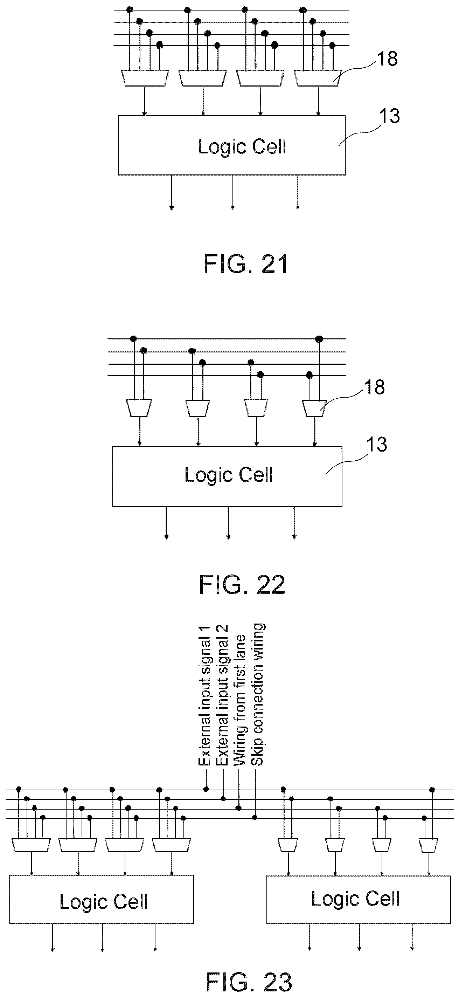

As yet another example, the wiring shown in Figs. 21-26 may also be possible in each lane of this embodiment.

In an example of Fig. 21, the number of inputs to each input selector 18 of the logic cell 13 is four. Whereas, in another example shown in Fig. 22, the number of inputs to each input selector 18 of the logic cell 13 is two. The input wiring of any the input selectors 18 of the above Fig. 21 may be selected from the external input signal lines, the wiring from the first lane, or the skip connection wiring. On the other hand, in the input selectors 18 of the logic cell 13 of Fig. 22, the number of inputs is reduced by half. In this case, as shown in Fig. 22, it is preferable to shift the selected wiring. In this example, the shift increment is set to 1, but it is not limited to this, and it may be shifted by n, or any two wires may be selected.

Moreover, in this example, the number of inputs to the input selectors is reduced from four to two, but instead the original number of inputs may be reduced. For example, if the original number of inputs is 20 (external inputs, first lane, skip wiring), this may be reduced to eight inputs. In this case, the 20 inputs may be arranged appropriately, and eight input wires may be selected by shifting them one at a time.

Additionally, as shown in Fig. 23, the logic cell 13 of Fig. 21 and the logic cell 13 of Fig. 22 may be arranged side by side within one lane and connected by wiring.

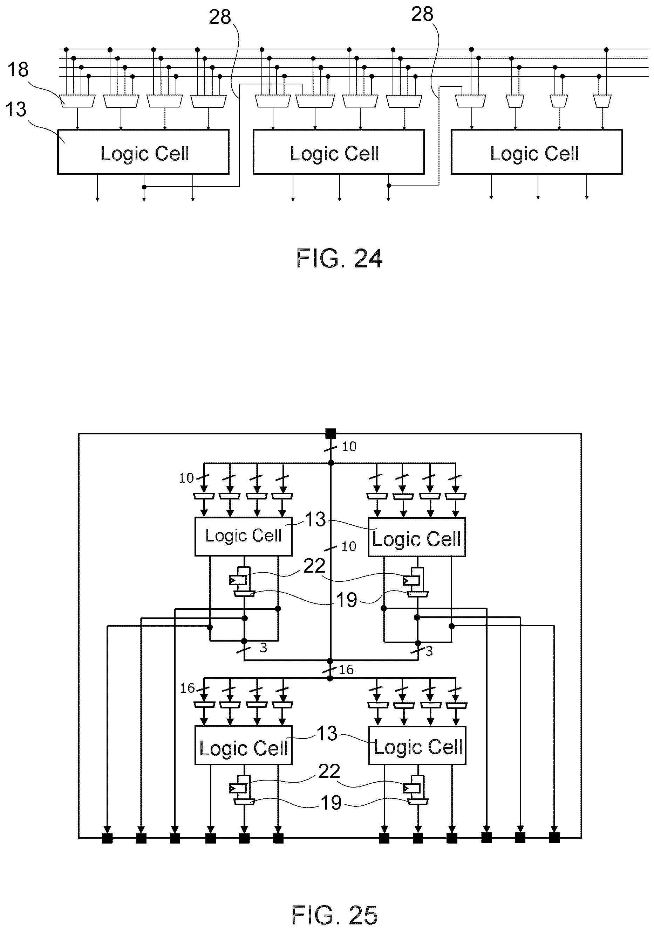

Furthermore, as shown in Fig. 24, wiring 28 may be provided such that within one lane, an output of one logic cell 13 is connected to an input selector 18 of another logic cell 13 (in this example, an adjacent logic cell).

In the example shown in Fig. 4, FFs were connected to all outputs of the logic cells 13, respectively, but as shown in Fig. 25, FFs may be connected to only some of the outputs rather than all outputs. In this example, FFs are connected to only one of the three outputs.

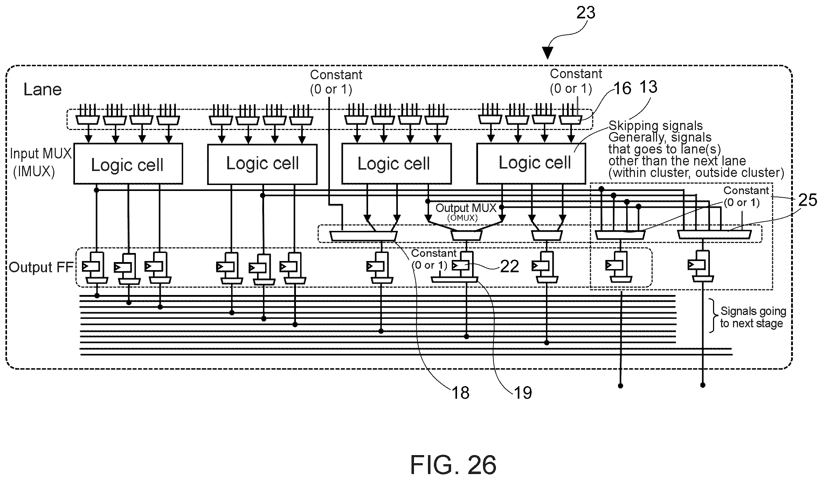

Furthermore, shown in Fig. 26 is a variation example of the example shown in Fig. 6. In this example, similarly to the example shown in Fig. 9, four logic cells are arranged in one lane 23. In addition, one output selector circuit 18 is shared between two output terminals of logic cells 13, and wiring and signal selectors 25 (multiplexers) are provided to extract skipping signals (signals that goes to lanes other than the next lane). However, this example is configured so that one selector 18 and one selector 25 are each provided with an input for giving a constant (0 or 1) from a memory or external input provided in this logic block, enabling an output selected from not only the output values from the above logic selectors, but also the above constant. Moreover, in this example, not only to the output selectors 18 and 25, constant inputs are also provided to one input selector 16 of a logic cell 13 and one output FF 19 Note that, in the case of lanes in configurations such as ones shown in Figs. 21-26, even if a logic block 10 does not necessarily have two or more lanes, a certain effect may be obtained in terms of reducing the component memories and implementation area.

Furthermore, in the above embodiment, the logic cells are assumed to be LUTs and PAEs, but these may be used in combination. For example, LUTs and PAEs may be used in combination as logic cells within one lane, or for each lane, it may be a lane using LUTs or one using PAEs. Additionally, within one FPGA, as logic cells, programmable logic circuits using only LUTs and programmable logic circuits using only PAEs may be mixed and implemented.

Moreover, in the above embodiment, the numbers of logic cells used in the first lane and the second lane were the same, but the number of logic cells used may be different between lanes.

Furthermore, in the above embodiment, the programmable logic circuit (each PA, PX, PAE circuit) of the present invention was incorporated into the logic blocks of the FPGA, but they may also be applied to reconfigurable logic devices other than FPGAs. That is, the most direct application example of the present BLE is in eFPGAs (embedded FPGAs). When providing a reconfigurable logic area within a SoC (System-on-Chip) or an ASIC (Application-Specific Integrated Circuit), by incorporating therein the programmable logic circuit of the present invention, high-level control may be achieved while ensuring area efficiency and flexibility.

**Description of the Reference Numbers**

    1. FPGA
    2. Logic block
    3. Switch block
    4. Connection block
    5. LUT
    6. Local connection block
    8. Netlist
    10. Logic block
    11. First lane
    12. Second lane
    13. Logic cell
    16, 17. Input selector circuit
    18, 19. Output selector circuit
    21, 22. Output flip-flop
    23. Lane
    25. Signal selector
    26. PAE circuit
    27. PA circuit

**Claims**

1.  A programmable logic circuit, comprising:

        a plurality of lanes sequentially connected in the programmable logic circuit in a direction of flow of input signals of this programmable logic circuit,
        wherein each of the plurality of lanes has one or more logic cells, inputs input signals into the lane to each logic cell via a program-controllable input-side selector circuit, and outputs output signals from each logic cell as input signals into a next sequential lane connected to this lane or/and outputs the output signals as output signals of this programmable logic circuit,
        wherein the logic cell has
        basic logic cells constituting nodes of a gate-level netlist,
        wherein the basic logic cells are programmable circuits configured by adding programmable NOT circuits to an input and an output of a basic logic operation element.

2. The programmable logic circuit of Claim 1, wherein
input signals of the each lane include input signals of the programmable logic circuit.

3. The programmable logic circuit of Claim 2, wherein
at least one of the lanes receives the input signals of the programmable logic circuit from a previous sequential lane that this lane is connected to.

4. The programmable logic circuit of Claim 1, wherein
at least one of the lanes has wiring for feeding back output signals from the logic cells as input signals of a previous sequential lane that this lane is connected to, or as input signals of this lane.

5. The programmable logic circuit of Claim 1, wherein
at least one of the lanes has wiring for feeding forward output signals from the logic cells as input signals of a next sequential lane that this lane is connected to.

6. The programmable logic circuit of Claim 1, wherein
at least one of the lanes has wiring for skip-outputting output signals from the logic cells as input signals of another programmable logic circuit.

7. The programmable logic circuit of Claim 1, wherein

wherein the logic cell is
made programmable to switch inputs and outputs of the basic logic cells depending on connection relationships of the nodes in the netlist.

8. The programmable logic circuit of Claim 7, wherein

wherein the logic cell comprises
a combinational logic cell composed by combining a plurality of the basic logic cells,
wherein the combinational logic cell comprises a plurality of basic logic cells which cover a plurality of nodes constituting a graph of the netlist.

9. The programmable logic circuit of Claim 8, wherein

when a number of the basic logic cells that are combined is n, an integer equal to 2 or greater, and a number of inputs to each basic logic cell is m, an integer equal to 2 or greater,
the combinational logic cell is
a logic cell of $(m-1) \times n + 1$ inputs and n outputs, having n of basic logic cells with their input signals switch-ably combined and connected, in order to represent two or more patterns of node connections.

10. The programmable logic circuit of Claim 8, wherein

the combinational logic cell has a plurality of outputs;
one or more of selectors provided so that at least two or greater output signals from the combinational logic cell are entered therein, and configured so as to output selected signals; and
a flip-flop (FF) provided so that output signals from the selector are entered therein.

11. The programmable logic circuit of Claim 10, wherein
the one or more of selectors are further provided so that a constant signal is entered therein.

12. The programmable logic circuit of Claim 1, wherein
this programmable logic circuit is a logic block of an FPGA.

13. An FPGA implemented with the programmable logic circuit of Claim 1 as a logic block.

14. A programmable logic circuit implemented in a logic block (LB) constituting an FPGA,

the programmable logic circuit comprising:

a combinational logic cell (PAE) composed by combining a plurality of basic logic cells (PAs), and programmed so as to switch inputs and outputs of the basic logic cells depending on connection relationships of nodes in a netlist, for outputting a plurality of output signals; and
one or more of selectors provided so that at the least two or greater output signals from the combinational logic cell are entered therein, and configured so as to output selected signals.

15. The programmable logic circuit of Claim 14, further comprising
a flip-flop (FF) provided on a latter stage of the selectors and provided so that output signals from the selector are entered therein.

FIG. 1

2

6

10

LCB (Local Connection Block)
For 4 logic cells, full crossbar connection 22inputs × 16 outputs
(10 External inputs + 12 feedback lines (3 outputs × 4) = 22, 16 logic cell inputs (4 inputs × 4))

| LUT | LUT | LUT | LUT |

5

5          5          5

FIG. 2

i8    i7    i6    i5      i4      i3    i2    i1    i0

p2

p1

p3

p4

8

p5

p8

p7

PO[2]          PO[1]          PO[0]

FIG. 3

FIG. 4

FIG. 5

FIG. 6

Lane
Input MUX (IMUX)
Logic cell
Output MUX (OMUX)
Output FF
Signals going to next stage

Skipping signals
Generally, signals that goes to lane(s) other than the next lane (within cluster, outside cluster)

13
23
25
16'
18'

FIG. 7

Skipped signals (Signals from lane(s) other than previous one)

Skipping signals Generally, signals that goes to lane(s) other than the next lane (within cluster, outside cluster)

Signals going to next stage

Lane
Input MUX (IMUX)
Logic cell
Output MUX (OMUX)
Output FF

Skipping signals Generally, signals that goes to lane(s) other than the next lane (within cluster, outside cluster)

Signals going to next stage

Lane
Input MUX (IMUX)
Logic cell
Output MUX (OMUX)
Output FF

23

23

FIG. 8

EP 4 683 228 A1

FIG. 9

(a)

(b) Constitute one node of
AIG with one PA (equivalent to 2-LUT)

FIG. 10

FIG. 11

FIG. 12

FIG. 13

FIG. 14

FIG. 15

FIG. 16

FIG. 17

(a)                    (b)

FIG. 18

(a) NAND gate    (b) NOR gate    (c) OR gate

FIG. 19

(a)    (b)

FIG. 20

18

13

Logic Cell

FIG. 21

18

13

Logic Cell

FIG. 22

External input signal 1
External input signal 2
Wiring from first lane
Skip connection wiring

Logic Cell

Logic Cell

FIG. 23

18

13

28

28

Logic Cell

Logic Cell

Logic Cell

FIG. 24

10

10

10

10

Logic Cell

13

Logic Cell

22

19

3

3

16

16

Logic Cell

13

Logic Cell

22

19

FIG. 25

EP 4 683 228 A1

FIG. 26

Europäisches
Patentamt
European
Patent Office
Office européen
des brevets

## EUROPEAN SEARCH REPORT

**Application Number**

EP 25 19 0317

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,P | EP 4 507 201 A1 (UNIV KUMAMOTO NAT UNIV CORP [JP]) 12 February 2025 (2025-02-12) * paragraphs [0021], [0022]; figures 3,4,5 * * paragraph [0035]; figures 8,9 * * paragraph [0058] * ----- | 1-9, 12-14 | INV. H03K19/173 H03K19/17728 H03K19/17736 |
| X | US 2014/347096 A1 (AFSHAR HADI PARANDEH [CH] ET AL) 27 November 2014 (2014-11-27) * paragraphs [0040] - [0044]; figure 1 * * paragraph [0082]; figure 8 * ----- | 1-15 | |

**TECHNICAL FIELDS SEARCHED (IPC)**

H03K

The present search report has been drawn up for all claims

| Place of search | Date of completion of the search | Examiner |
|---|---|---|
| Munich | 3 December 2025 | Martínez Martínez, J |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

 

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 19 0317

This annex lists the patent family members relating to the patent documents cited in the above-mentioned European search report.
The members are as contained in the European Patent Office EDP file on
The European Patent Office is in no way liable for these particulars which are merely given for the purpose of information.

03-12-2025

| Patent document cited in search report | | Publication date | Patent family member(s) | | Publication date |
|---|---|---|---|---|---|
| EP 4507201 | A1 | 12-02-2025 | CN | 119441122 A | 14-02-2025 |
| | | | EP | 4507201 A1 | 12-02-2025 |
| | | | JP | 7657432 B2 | 07-04-2025 |
| | | | JP | 2025024399 A | 20-02-2025 |
| | | | TW | 202507554 A | 16-02-2025 |
| | | | US | 2025055461 A1 | 13-02-2025 |
| US 2014347096 | A1 | 27-11-2014 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2024115447 A
- JP 2025099933 A

- JP 2025114053 A